# EUROPÄISCHE PATENTSCHRIFT

(11) **EP 1 079 431 B1**
(45) Veröffentlichungstag und Bekanntmachung des Hinweises auf die Patenterteilung: **07.06.2006**
(21) Anmeldenummer: 00115981.3
(22) Anmeldetag: 26.07.2000
(51) Int. Cl.: H01L 23/10, B81B 7/00

(54) **Verfahren zur Verkappung eines Bauelements mit einer Kavernenstruktur**
Encapsulation process for components with cavities
Procédé d'encapsulation pour composants avec cavités

(30) Priorität: 26.08.1999 DE 19940512
(43) Veröffentlichungstag der Anmeldung: 28.02.2001
(73) Patentinhaber: ROBERT BOSCH GMBH, 70442 Stuttgart (DE)
(72) Erfinder: Artmann, Hans, 71106 Magstadt (DE); Frey, Wilhelm, Dr., 9430 Palo Alto (US); Laermer, Franz, Dr., 70437 Stuttgart (DE)

(56) Entgegenhaltungen:
- DE-A- 19 730 975
- DE-A- 19 803 013
- DE-C- 19 602 318
- PATENT ABSTRACTS OF JAPAN Bd. 0181, Nr. 41 (E-1520), 9. März 1994 (1994-03-09) & JP 5 326738 A (KYOCERA CORP), 10. Dezember 1993 (1993-12-10)
- ARTMANN H ET AL: "Porous silicon technique for realization of surface micromachined silicon structures with large gaps" SENSORS AND ACTUATORS A, ELSEVIER SEQUOIA S.A., LAUSANNE, CH, Bd. 74, Nr. 1-3, 20. April 1999 (1999-04-20), Seiten 104-108, XP004188067 ISSN: 0924-4247

## Beschreibung

Die Erfindung betrifft ein Verfahren zur Verkappung eines Bauelementes, insbesondere eines mikromechanischen Bauelementes oder Sensorelementes, mit einer Kavernenstruktur.

### Stand der Technik

Es ist bekannt, mikromechanische Sensorelemente oder Bauteile nach deren Aufbau auf einem Siliziumwafer in einem Metallgehäuse mit anschließendem Zuschweißen in Einzelverarbeitung zu verkappen, um diese vor Gasen, Staub, Wasser oder sonstigen Verunreinigungen zu schützen und eine Funktionsbeeinträchtigung zu vermeiden. Weiterhin ist bekannt, einen Siliziumkappenwafer, der zuvor mit einer KOH-Lösung strukturiert wurde, auf einen Sensorwafer zu bonden (sogenanntes "Waferscale-Packaging"), um damit auf dem Sensorwafer befindliche mikromechanische Sensorelemente oder Bauteile zu verkappen. Das Bonden erfolgt dabei üblicherweise über Sealglas. Beide Methoden werden beispielsweise erfolgreich in der Serienproduktion mikromechanischer Sensoren eingesetzt.

In beiden Fällen sind jedoch die sehr hohen Kosten für die Verkappung der Sensoren oder Bauelemente mit diesen Verfahren nachteilig, die bis zu 50% der Gesamtkosten ausmachen können.

Die Herstellung von porösem Silizium und die epitaktische Abscheidung von Silizium auf porösem Silizium mittels des sogenannten Ψ-Prozesses ist aus der Anmeldung DE 197 30 975.5 bekannt.

Weiter ist aus der JP-5326738 A ein von einem Substrat getragenes Bauelement bekannt, wobei das Bauelement auf der Oberfläche des Substrates derart mit einer Kaverne eines mit einer Kavernenstruktur versehenen Schichtsystems überstülpt ist, dass die Kaverne und das Substrat das Bauelement zumindest weitgehend umhüllen. Das Schichtsystem umfasst eine Deckschicht und zwei Glasschichten. Weitere Schichten, insbesondere eine Trennschicht zur Unterstützung einer einfacheren Verkappung, ist nicht vorgesehen.

Aufgabe der vorliegenden Erfindung war die Entwicklung eines Verfahrens, mit dem die Verkappung eines Bauelementes auf einem Tragkörper mit einem eine Kavernenstruktur aufweisenden Schichtsystem erleichtert wird.

### Vorteile der Erfindung

Das erfindungsgemäße Verfahren mit den Merkmalen des Anspruchs 1 hat gegenüber dem Stand der Technik den Vorteil, daß es eine einfachere und zuverlässigere Verkappung von insbesondere beweglichen Sensorelementen oder Bauelementen erlaubt. Hierfür weist das Schichtsystem vor der Verkappung zumindest einen Grundkörper, eine Trennschicht und eine Deckschicht auf. Dabei kann vorteilhaft der eingesetzte Grundkörper oder der verbliebene Teil des Schichtsystems nach einem Verfahrensdurchlauf mehrfach wiederverwertet werden.

Weiterhin handelt es sich bei dem erfindungsgemäßen Verfahren um ein Verfahren auf Waferlevel, so daß eine aufwendige Einzelverkappung der zu schützenden Bauelemente und eine Einzeljustage der einzelnen Kavernen entfallen kann. Auch die Handhabung des mit den Bauelementen versehenen Wafers und des mit der Kavernenstruktur versehenen Wafers ist deutlich vereinfacht.

Daneben kann die Form der erzeugten Kavernen in einfacher Weise an die jeweils zu verkappenden Bauelemente angepaßt werden.

Vorteilhafte Weiterbildungen der Erfindung ergeben sich aus den in den Unteransprüchen genannten Maßnahmen.

Besonders vorteilhaft ist, wenn als Trennschicht eine Opferschicht aus porösem Silizium eingesetzt wird. Die auf der Trennschicht erzeugte Deckschicht besteht weiter vorteilhaft aus epitaktisch aufgewachsenem Silizium oder aus gegenüber der Trennschicht niedrigporösem Silizium.

Weiterhin werden im Laufe des erfindungsgemäßen Verfahrens vorteilhaft lediglich jeweils an sich bekannte Verfahrensschritte eingesetzt, die technisch gut beherrschbar und mit der Siliziumhalbleitertechnolgie kompatibel sind.

Für gewisse Anwendungen kann es weiter vorteilhaft sein, wenn die Kaverne zum Schutz eines Bauelementes zumindest schwach gasdurchlässig ist. Dies kann in einfacher Weise mit Hilfe des erfindungsgemäßen Verfahrens ohne wesentliche zusätzliche Verfahrensschritte erreicht werden.

### Zeichnung

Die Erfindung wird anhand der Zeichnung und der nachfolgenden Beschreibung näher erläutert. Es zeigt Figur 1 einen Siliziumwafer mit einem Schichtsystem mit einer oberflächlichen Kavernenstruktur gemäß dem ersten Ausführungsbeispiel, Figur 2 einen Siliziumwafer mit einem Schichtsystem mit einer oberflächlichen Kavernenstruktur gemäß dem zweiten Ausführungsbeispiel, Figur 3 einen Siliziumwafer mit einem Schichtsystem mit einer oberflächlichen Kavernenstruktur gemäß dem dritten Ausführungsbeispiel und Figur 4 ein mit der Kavernenstruktur verkapptes Bauelement auf einem Siliziumwafer.

### Ausführungsbeispiele

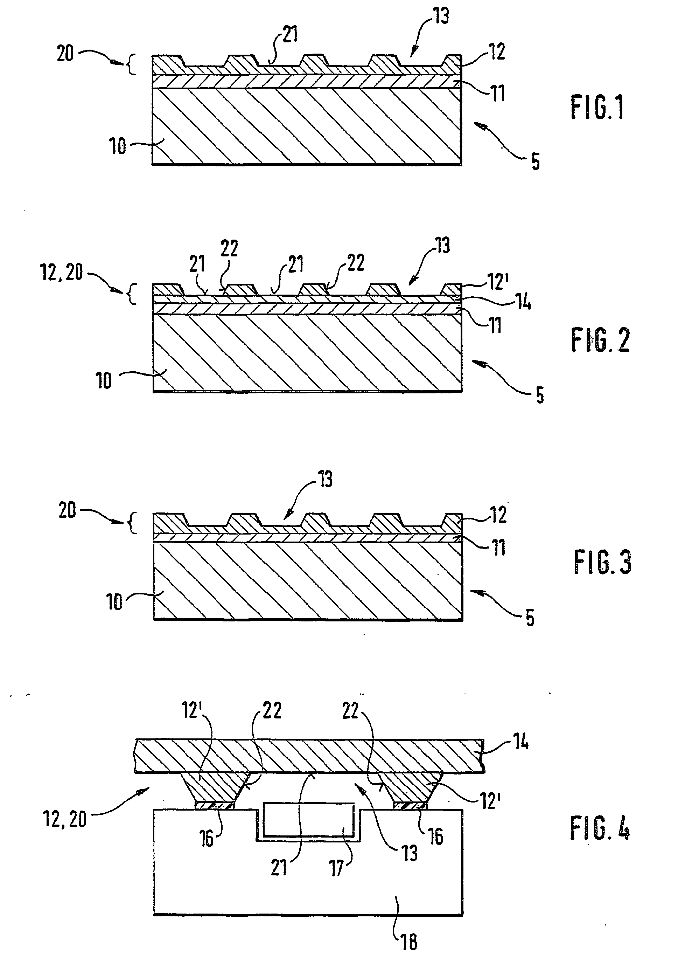

Die Figur 1 erläutert als erstes Ausführungsbeispiel die Erzeugung einer Kavernenstruktur 20 zur späteren kostengünstigen Dünnschichtverkappung eines Bauelementes 17, insbesondere eines mikromechanischen Sensorelementes, das aus einem Tragkörper 18 herausstrukturiert wurde, der beispielsweise aus Silizium besteht.

Zunächst wird auf einem Grundkörper 10, der im konkreten Beispiel ein Siliziumwafer oder Siliziumkörper ist, oberflächlich eine Trennschicht 11 aus porösem Silizium erzeugt, die im späteren als Sollbruchschicht oder Opferschicht dient und eine Dicke von 1 µm bis 10 µm, bevorzugt ca. 5 µm hat. Die Erzeugung der Trennschicht 11 erfolgt dabei nach dem aus DE 197 30 975.5 bekannten Verfahren. Der Grundkörper 10, die Trennschicht 11 und die Deckschicht 12 bilden somit ein Schichtsystem 5.

Anschließend wird dann auf der Trennschicht 11 eine Deckschicht 12 aufgebracht, die beispielsweise aus epitaktisch aufgewachsenem, weitgehend einkristallinem Silizium besteht. Das epitaktische Aufwachsen erfolgt dabei bevorzugt mittels einer ionenassistierten Deposition d.h. einem Niedertemperatur-Epitaxieverfahren bei Temperaturen unterhalb 650°C. Ein derartiges Verfahren ist in S. Oelting, Proc. 13^{th} European Photovoltaic Solar Energy Conf., Nice, France, 23.-27.10.95, "Ion Assisted Deposition of Crystalline Thin Film Silicon Solar Cells", beschrieben. Alternativ kann die Abscheidung der Deckschicht 12 auch in an sich bekannter Weise über die Abscheidung von Polysilizium oder α-Silizium mit anschließender thermischer Rekristallisation bei Temperaturen oberhalb 600°C erfolgen oder - nach geeigneter Vorbehandlung der Trennschicht 11 - auch über ein an sich bekanntes LPCVD-Verfahren ("Low Pressure Chemical Vapour Deposition") oder APCVD-Verfahren ("Atmospheric Pressure Chemical Vapour Deposition") zur Abscheidung von einkristallinem Silizium oder Polysilizium.

Danach wird die aufgebrachte Deckschicht 12 derart strukturiert, daß eine Kavernenstruktur 20 entsteht, die bevorzugt aus einer regelmäßigen Anordnung von einzelnen Kavernen 13 besteht. Unter Kavernen 13 werden dabei im Rahmen der Erfindung Ausnehmungen aus der Deckschicht 12 verstanden, die einen weitgehend beliebigen, bevorzugt rechteckigen, quadratischen oder kreisförmigen Grundriß haben. Bevorzugt sind Kavernen 13, die eine wannenartige Form d.h. eine abgeschrägte Seitenwand 22 und einen rechteckigen oder kreisförmigen Boden 21 haben. Die Kavernenstruktur 20 kann im übrigen auch lediglich eine Kaverne 13 aufweisen.

Die Strukturierung der Decksicht 12 mit der Kavernenstruktur 20 erfolgt dabei bevorzugt über Hochratenplasmaätzverfahren, wie sie beispielsweise aus DE 42 41 045 bekannt sind. Sofern die Deckschicht 12 aus epitaktisch aufgewachsenem, weitgehend einkristallinem Silizium besteht, eignet sich zur Erzeugung der Kavernenstruktur 20 weiter auch eine Ätzung in einer KOH-Lösung oder einer Tetramethylammoniumhydroxid-Lösung (TMAH-Lösung).

Zur Verkappung eines Bauelementes 17, das aus der Oberfläche eines Tragkörpers 18 herausstrukturiert oder auf dessen Oberfläche angeordnet wurde, und das beispielsweise ein mikromechanisches Sensorelement ist, wird danach die Kavernenstruktur 20 gemeinsam mit dem diese tragenden Grundkörper 10 bzw. Schichtsystem 5 kopfüber auf dem Tragkörper 18 präzise justiert und mit dem Tragkörper 18 verbunden. Dies wird mit Hilfe der Figur 4 erläutert. Diese Verbindung erfolgt in an sich bekannter Weise über Sealglas oder hermetisch verdichteten Polymerklebstoff in Kontaktbereichen 16 zwischen der Kavernenstruktur 20 und dem Tragkörper 18 d.h. zwischen den Materialien der Deckschicht 12 und dem Tragkörper 18, die sich in den Kontaktbereichen 16 bevorzugt nahezu berühren.

Damit wird nun das Bauelement 17 von dem Tragkörper 18 und der dem Tragkörper 18 überstülpten, zumindest weitgehend gasdichten Kavernenstruktur 20 zumindest weitgehend umhüllt, wobei die Kaverne 13 im erläuterten Beispiel derart dimensioniert ist, daß sie das Bauelement 17, das beispielsweise ein mikromechanisches Beschleunigungssensorelement ist, nicht berührt.

Abschließend wird nach dem Verbinden von Tragkörper 18 und Kavernenstruktur 20 die mit der Kavernenstruktur 20 versehene Deckschicht 12 von dem Grundkörper 10 gelöst. Dies geschieht, indem durch mechanischen Zug oder eine Scherung die als Sollbruchschicht dienende Trennschicht 11, die die Deckschicht 12 von dem Grundkörper 10 trennt, aufgebrochen wird, so daß die Verbindung zwischen Deckschicht 12 und Tragkörper 10 gelöst wird. Anschließend wird dann der Grundkörper 10 und gegebenenfalls die Deckschicht 12 von anhaftenden Resten der Opferschicht 11 befreit, so daß der Grundkörper 10 für einen weiteren Verfahrenszyklus erneut verwendet und damit erneut ein Schichtsystem 5 erzeugt werden kann.

Die Figur 2 zeigt als zweites Ausführungsbeispiel der Erfindung, wie in Abwandlung des zuvor beschriebenen Verfahrens auf dem Grundkörper 10, der beispielsweise ein Siliziumwafer oder Siliziumkörper ist, zunächst zwei übereinanderliegende Schichten, die Trennschicht 11 aus porösem Silizium und eine gering poröse Teilschicht 14 erzeugt werden. Die gering poröse Teilschicht 14 wird dabei im späteren eine Teilschicht der zuvor bereits erläuterten Deckschicht 12.

Unter einer gering porösen Schicht wird dabei eine Schicht verstanden, die eine offene Porosität von 5 % bis 30 % aufweist. Die poröse Trennschicht 11 ist dagegen bevorzugt eine hochporöse Schicht mit einer offenen Porosität von 30 % bis 70 %.

Zur Erzeugung der Schichten 11, 14 wird im einzelnen zunächst die Oberfläche des Grundkörpers 10, wie zuvor bereits beschrieben, flächig anodisiert. Durch geeignete Einstellung der Prozeßparameter beim Anodisieren d.h. der Elektrolytkonzentration und der Anodisierstromdichte kann bekanntermaßen die sich ergebende Porosität der jeweiligen Schicht eingestellt werden.

Zunächst wird daher aus der Oberfläche des Grundkörpers 10 durch flächiges Anodisieren mit einer 20%-igen bis 33%-igen, ethanolischen Flußsäurelösung bei einer Stromdichte von 1 mA/cm² bis 10 mA/cm² die niedrig poröse Teilschicht 14 erzeugt. Anschließend wird das Anodisieren dann mit einer 20%-igen bis 33%-igen, ethanolischen Flußsäurelösung bei einer Stromdichte von 10 mA/cm² bis 50 mA/cm² fortgesetzet, so daß unter der niedrig porösen Teilschicht 14 die hochporöse Trennschicht 11 entsteht.

Die Dicke der Trennschicht 11 beträgt dabei 1 µm bis 10 µm, bevorzugt ca. 5 µm. Die niedrig poröse Teilschicht 14 hat bevorzugt eine Dicke von 1 µm bis 10 µm.

Im weiteren wird dann auf die niedrig poröse Teilschicht 14 eine Teildeckschicht 12' aufgebracht, die beispielsweise aus epitaktisch aufgewachsenem, weitgehend einkristallinem Silizium besteht und eine bevorzugte Dicke von 2 µm bis 10 µm hat. Das epitaktische Aufwachsen erfolgt dabei analog dem ersten Ausführungsbeispiel. Die Teildeckschicht 12' und die gering poröse Teilschicht 14 bilden somit die Deckschicht 12. In besonders bevorzugter Ausgestaltung des Ausführungsbeispiels wird vor dem epitaktischen Aufwachsen der Teildeckschicht 12' zusätzlich zunächst eine Voraboxidation der niedrig porösen Teilschicht 14 vorgenommen. Diese Voraboxidation betrifft besonders die Poren der Teilschicht 14 und verhindert ein Zusammensintern dieser Poren bei höheren Temperaturen. Sie erfolgt bei Temperaturen von 300°C bis 400°C über einen Zeitraum von 10 min bis 30 min.

Im nächsten Verfahrensschritt wird dann die Deckschicht 12 mit einer der bereits im ersten Ausführungsbeispiel beschriebenen Verfahren derart strukturiert, daß eine Kavernenstruktur 20 entsteht, die bevorzugt aus einer regelmäßigen Anordnung von einzelnen Kavernen 13 besteht. Bevorzugt wird dabei die Deckschicht 12 derart strukturiert, daß die Böden 21 der einzelnen Kavernen 13 der Kavernenstruktur 20 von der niedrig porösen Teilschicht 14 gebildet werden, während die Seitenwände 22 durch die epitaktisch aufgewachsene Teildeckschicht 12' gebildet werden. Auf diese Weise wird erreicht, daß die Böden 21 der Kavernen 13 gasdurchlässig jedoch staub- und wasserdicht sind, während die Seitenwände 22 neben staub- und wasserdicht auch zumindest weitgehend gasdicht sind. Es ist jedoch offensichtlich, daß das erläuterte Ausführungsbeispiel auch dahingehend abgewandelt werden kann, daß die gesamte Deckschicht 12 aus einem niedrig porösen Material, insbesondere niedrig porösem Silizium besteht und damit die gesamte Kavernenstruktur 20 zwar staub- und wasserdicht, jedoch zumindest teilweise gasdurchlässig ist.

Mit dem gemäß Figur 2 vorbereiteten Grundkörper 10 und den erzeugten Schichten bzw. dem erzeugten Schichtsystem 5 wird dann zur Verkappung des Bauelementes 17 wie bereits im ersten Ausführungsbeispiel und mit Hilfe der Figur 4 erläutert, weiterverfahren, d.h. die Kavernenstruktur 20 wird gemeinsam mit dem diese tragenden Grundkörper 10 kopfüber auf dem Tragkörper 18 präzise justiert und mit dem Tragkörper 18 verbunden, so daß das Bauelement 17 von dem Tragkörper 18 und einer der dem Tragkörper 18 überstülpten Kaverne 13 der Kavernenstruktur 20 umhüllt wird. Die Böden 21 der Kavernen 13 bilden dabei nun einen gasdurchlässigen Deckel der einzelnen Kavernen 13. Abschließend wird dann nach dem Verbinden von Tragkörper 18 und Kavernenstruktur 20 durch mechanischen Zug oder eine Scherung die als Sollbruchschicht dienende Trennschicht 11 aufgebrochen, so daß die Verbindung zwischen Deckschicht 12 und Tragkörper 10 gelöst wird.

Ein drittes Ausführungsbeispiel der Erfindung wird mit Hilfe der Figur 3 erläutert. Dazu wird auf einem Siliziumwafer als Grundkörper 10 zunächst eine Abfolge von mindestens zwei Schichten aus porösem Silizium mit jeweils unterschiedlicher Porosität erzeugt. Die Porosität dieser beiden Schichten wird dazu analog dem zweiten Ausführungsbeispiel jeweils über die Anodisierungsparameter definiert. Konkret wird zunächst eine niedrig poröse obere Schicht erzeugt, die eine Porosität von 10 % bis 20 % und eine Dicke von 5 µm bis 20 µm hat. Dies erfolgt bevorzugt durch Anodisieren mit einer 20%-igen bis 33%-igen, ethanolischen Flußsäurelösung bei einer Stromdichte von 1 mA/cm² bis 10 mA/cm² bei Raumtemperatur. Diese obere Schicht bildet im weiteren die Deckschicht 12.

Anschließend wird dann eine hochporöse untere Schicht mit einer Porosität von 30 % bis 60 % und eine Dicke von 5 µm bis 10 µm erzeugt. Dies erfolgt erneut bevorzugt durch Anodisieren mit einer 20%-igen bis 33%-igen, ethanolischen Flußsäurelösung bei einer Stromdichte von 1 mA/cm² bis 10 mA/cm² bei Raumtemperatur. Diese untere Schicht bildet dann im weiteren die Trennschicht 11.

Anschließend wird dann der Grundkörper 10 mit den erzeugten Schichten 11, 12 aus porösem Silizium derart getempert, daß die niedrig poröse obere Schicht (Deckschicht 12) verdichtet wird, während gleichzeitig die Stabilität der unteren Schicht (Trennschicht 11) weiter reduziert wird. Dazu wird der Grundkörper 10 mit den erzeugten Schichten aus porösem Silizium beispielsweise bei 900°C bis 1100°C in H₂₋Atmosphäre über einen Zeitraum von 1 min bis 30 min getempert.

Im weiteren wird dann analog dem ersten Ausführungsbeispiel weiterverfahren d.h. es folgt die Strukturierung der nun verdichteten, weitgehend gasdichten oder niedrig porösen Deckschicht 12 mit der Kavernenstruktur 20 und die bereits anhand der Figur 4 erläuterte Verkappung des Bauelementes 17.

Das dritte Ausführungsbeispiel hat den Nachteil, daß der Grundkörper 10 gegenüber den anderen Ausführungsbeispielen schneller verbraucht ist, da die Dicke der Deckschicht 12 zusätzlich zur Dicke der Trennschicht 11 bei jedem Zyklus verbraucht wird. Gleichzeitig hat man dabei aber den Vorteil, daß kein Epitaxieschritt zum Erzeugen der Deckschicht 12 erforderlich ist, was je nach Anlagendimensionierung kostengünstiger sein kann.

In den vorstehenden Ausführungsbeispielen ist es im übrigen nicht zwingend, daß die Trennschicht 11 von einem oberflächlichen Bereich des Grundkörpers 10 gebildet wird. Es ist ebenso möglich, daß auf dem Grundkörper 10 zunächst eine zusätzliche Schicht abgeschieden wird, die im weiteren porosiert wird und dann die Trennschicht 11 bildet.

Schließlich ist es in leichter Modifikation der vorstehend erläuterten Ausführungsbeispiele offensichtlich auch möglich, daß der Grundkörper 10 schon vor der Erzeugung der Trennschicht 11 bzw. der Deckschicht 12 bereits in mit Kavernen versehener, strukturierter Form vorliegt. Dazu wird die Oberfläche des Grundkörpers 10 zunächst über ein an sich bekanntes Strukturierungsverfahren mit einer Struktur versehen, die analog der Kavernenstruktur 20 ausgebildet ist. Auf dieser Struktur an der Oberfläche des Grundkörpers 10 wird dann die Trennschicht 11 in der erläuterten Weise erzeugt. Dabei kann die Trennschicht 11 entweder zusätzlich auf die strukturierte Oberfläche des Grundkörpers 10 aufgebracht werden, oder auch durch die oberflächennahen Bereiche des Grundkörpers 10 gebildet sein. Auf dieser Trennschicht 11, beispielsweise aus porösem Silizium, wird dann analog den vorstehenden Ausführungen die Deckschicht 12 erzeugt. Dabei kann die Deckschicht 12 beispielsweise wie vorstehend beschrieben, in Form von Polysilizium abgeschieden werden, als auch durch oberflächliches thermisches Verdichten in H₂-Atmosphäre einer porösen Teilschicht 14 erzeugt werden.

Bei dieser Verfahrensvariante überträgt sich somit die zunächst erzeugte oder bestehende Strukturierung der Oberfläche des Grundkörpers 10 auf die Trennschicht 11 und darüber auf die Deckschicht 12, so daß schließlich auch diese die Kavernenstruktur 20 aufweist, ohne daß die Kavernen 13 in einem eigenen Verfahrensschritt noch einmal aus der Deckschicht 12 herausstrukturiert werden müssen. Diese Vorgehensweise hat den Vorteil, daß aufgrund der geringen Dicke der Trennschicht 11 von einigen µm die Oberfläche des Grundkörpers 10 nicht nach jedem Zyklus zur Erzeugung der Kavernenstruktur 20 neu strukturiert werden muß, sondern für typischerweise 2 bis 5 Verfahrensdurchläufe verwendet werden kann, bevor die Strukturierung der Oberfläche des nach jedem Verfahrensdurchlauf verbliebenen Teil des Grundkörpers 10 nachgearbeitet oder neu hergestellt werden muß. Dadurch spart man also eine ansonsten bei jedem Verfahrensdurchlauf erforderliche Strukturierung der erzeugten Deckschicht 12 mit der Kavernenstruktur 20.

### Bezugszeichenliste

- 5: Schichtsystem
- 10: Grundkörper
- 11: Trennschicht
- 12: Deckschicht
- 12': Teildeckschicht
- 13: Kaverne
- 14: poröse Teilschicht
- 16: Kontaktbereich
- 17: Bauelement
- 18: Tragkörper
- 20: Kavernenstruktur
- 21: Boden
- 22: Seitenwand

## Patentansprüche

1. Verfahren zur Verkappung mindestens eines von einem Tragkörper (18) getragenen oder bereichsweise umgebenen Bauelementes (17) auf Waferlevel, insbesondere eines mikromechanischen Bauelementes oder Sensorelementes, wobei das Bauelement (17) auf der Oberfläche des Tragkörpers (18) bereichsweise derart mit einer Kaverne (13) eines mit einer Kavernenstruktur (20) versehenen Schichtsystems (5) überstülpt wird, daß die Kaverne (13) und der Tragkörper (18) das Bauelement (17) zumindest weitgehend umhüllen
**dadurch gekennzeichnet,**
**daß** das Schichtsystem (5) zumindest einen Grundkörper (10) aus einem zur Siliziumhalbleitertechnologie kompatiblen Material, insbesondere einen Siliziumkörper, eine Trennschicht (11) und eine Deckschicht (12) aufweist.

2. Verfahren nach Anspruch 1, **dadurch gekennzeichnet,**
**daß** die Deckschicht (12) mit der Kavernenstruktur (20) strukturiert wird.

3. Verfahren nach Anspruch 2, **dadurch gekennzeichnet,**
**daß** die Trennschicht (11) von einer Opferschicht gebildet wird.

4. Verfahren nach Anspruch 1, **dadurch gekennzeichnet,**
**daß** die Kaverne (13) und der Tragkörper (18) in einem Kontaktbereich (16) über Sealglas oder Polymerklebstoff verbunden sind.

5. Verfahren nach Anspruch 1, **dadurch gekennzeichnet, daß** die Kaverne (13) derart aufgebracht wird, daß die Kaverne (13) und das Bauelement (17) berührungsfrei sind.

6. Verfahren nach Anspruch 1, **dadurch gekennzeichnet, daß** die Schichtstruktur (5) mit der Kavernenstruktur (20) kopfüber mit dem Tragkörper (18) verbunden, insbesondere gebondet wird.

7. Verfahren nach Anspruch 6, **dadurch gekennzeichnet, daß** nach der Verbindung der Kavernenstruktur (20) mit dem Tragkörper (18) die Kavernenstruktur (20) von dem Grundkörper (10) getrennt wird.

8. Verfahren nach Anspruch 7, **dadurch gekennzeichnet, daß** das Trennen durch eine Auflösung oder einen Bruch der Trennschicht (11) erfolgt.

9. Verfahren nach Anspruch 2, **dadurch gekennzeichnet, daß** auf dem Grundkörper (10) zunächst die Trennschicht (11) und danach auf der Trennschicht (11) die Deckschicht (12) erzeugt wird.

10. Verfahren nach Anspruch 2, **dadurch gekennzeichnet, daß** auf dem Grundkörper (10) zunächst die Deckschicht (12) erzeugt und strukturiert und danach zwischen der strukturierten Deckschicht (12) und dem Grundkörper (10) die Trennschicht (11) erzeugt wird.

11. Verfahren nach Anspruch 9 oder 10, **dadurch gekennzeichnet, daß** die Deckschicht (12) und/oder die Trennschicht (11) auf dem Grundkörper (10) abgeschieden werden.

12. Verfahren nach Anspruch 9 oder 10, **dadurch gekennzeichnet, daß** die Deckschicht (12) und/oder die Trennschicht (11) von einem Oberflächenbereich des Grundkörpers (10) gebildet werden.

13. Verfahren nach Anspruch 2, **dadurch gekennzeichnet,**
**daß** als Trennschicht (11) eine poröse Siliziumschicht erzeugt wird.

14. Verfahren nach Anspruch 2, **dadurch gekennzeichnet,**
**daß** die Deckschicht (12) durch insbesondere epitaktisches Aufwachsen von Silizium auf dem Grundkörper (10) erzeugt wird.

15. Verfahren nach Anspruch 14, **dadurch gekennzeichnet, daß** das Aufwachsen in einem Niedertemperaturepitaxieprozeß mit einer ionenassistierten Deposition oder mittels eines CVD-Prozesses erfolgt.

16. Verfahren nach mindestens einem der vorangehenden Ansprüche, **dadurch gekennzeichnet, daß** die Oberfläche des Grundkörpers (10) zunächst mit einer Strukturierung versehen wird und danach die Trennschicht (11) und die Deckschicht (12) erzeugt werden, so daß sich die Strukturierung der Oberfläche des Grundkörpers (10) in die Deckschicht (12) überträgt und sich die Kavernenstruktur (20) ausbildet.

17. Verfahren nach mindestens einem der vorangehenden Ansprüche, **dadurch gekennzeichnet, daß** die Strukturierung der Schichtstruktur (5) oder der Deckschicht (12) mit der Kavernenstruktur (20) mit einem Plasmaätzverfahren, insbesondere einem Hochratenplasmaätzverfahren, oder einem naßchemischen Ätzverfahren, insbesondere einer Ätzung mit KOH-Lösung, erfolgt.

18. Verfahren nach mindestens einem der vorangehenden Ansprüche, **dadurch gekennzeichnet, daß** eine Deckschicht (12) erzeugt wird, die eine niedrig poröse Teilschicht (14) und eine zumindest weitgehend gasdichte Teildeckschicht (12') aufweist, oder daß eine niedrig poröse Deckschicht (12) erzeugt wird.

19. Verfahren nach mindestens einem der vorangehenden Ansprüche, **dadurch gekennzeichnet, daß** der Grundkörper (10) zunächst zumindest oberflächlich porosiert oder mit einer porösen Schicht versehen und anschließend derart getempert wird, daß sich eine verdichtete, niedrig poröse Schicht als Deckschicht (12) bildet, die von einer porösen Trennschicht (11) von dem Grundkörper (10) getrennt wird.

## Claims

1. Process for encapsulating at least one component (17) at the wafer level, said component being supported or surrounded in regions by a supporting body (18), in particular a micromechanical component or sensor element, the component (17) on the surface of the supporting body (18) having placed over it in regions a cavity (13) of a layer system (5) provided with a cavity structure (20) in such a way that the cavity (13) and the supporting body (18) at least largely envelope the component (17),
**characterized**
**in that** the layer system (5) has at least one basic body (10) made of a material compatible with silicon semiconductor technology, in particular a silicon body, a separating layer (11) and a covering layer (12).

2. Process according to Claim 1, **characterized in that** the covering layer (12) is patterned with the cavity structure (20).

3. Process according to Claim 2, **characterized in that** the separating layer (11) is formed by a sacrificial layer.

4. Process according to Claim 1, **characterized in that** the cavity (13) and the supporting body (18) are connected in a contact region (16) by means of sealing glass or polymer adhesive.

5. Process according to Claim 1, **characterized in that** the cavity (13) is applied in such a way that the cavity (13) and the component (17) are free of contact.

6. Process according to Claim 1, **characterized in that** the layer structure (5) with the cavity structure (20) is connected, in particular bonded, headfirst to the supporting body (18).

7. Process according to Claim 6, **characterized in that** after the cavity structure (20) has been connected to the supporting body (18), the cavity structure (20) is separated from the basic body (10).

8. Process according to Claim 7, **characterized in that** the separation is effected by resolution or fracture of the separating layer (11).

9. Process according to Claim 2, **characterized in that** firstly the separating layer (11) is produced on the basic body (10) and then the covering layer (12) is produced on the separating layer (11).

10. Process according to Claim 2, **characterized in that** firstly the covering layer (12) is produced on the basic body (10) and patterned and then the separating layer (11) is produced between the patterned covering layer (12) and the basic body (10).

11. Process according to Claim 9 or 10, **characterized**
**in that** the covering layer (12) and/or the separating layer (11) are deposited on the basic body (10).

12. Process according to Claim 9 or 10, **characterized**
**in that** the covering layer (12) and/or the separating layer (11) are formed by a surface region of the basic body (10).

13. Process according to Claim 2, **characterized in that** a porous silicon layer is produced as the separating layer (11).

14. Process according to Claim 2, **characterized in that** the covering layer (12) is produced by, in particular, epitaxial growth of silicon on the basic body (10).

15. Process according to Claim 14, **characterized in that** the growth is effected in a low-temperature epitaxy process with an ion-assisted deposition or by means of a CVD process.

16. Process according to at least one of the preceding claims, **characterized in that** the surface of the basic body (10) is firstly provided with a patterning and then the separating layer (11) and the covering layer (12) are produced, so that the patterning of the surface of the basic body (10) is transferred into the covering layer (12) and the cavity structure (20) is formed.

17. Process according to at least one of the preceding claims, **characterized in that** the patterning of the layer structure (5) or of the covering layer (12) with the cavity structure (20) is effected by means of a plasma etching process, in particular a high-rate plasma etching process, or a wet-chemical etching process, in particular an etch using KOH solution.

18. Process according to at least one of the preceding claims, **characterized in that** a covering layer (12) is produced which has a partial layer (14) having low porosity and an at least largely gastight partial covering layer (12'), or **in that** a covering layer (12) having low porosity is produced.

19. Process according to at least one of the preceding claims, **characterized in that** the basic body (10) is firstly at least superficially rendered porous or provided with a porous layer and is subsequently subjected to heat treatment in such a way that a densified layer having low porosity is formed as covering layer (12), which is separated from the basic body (10) by a porous separating layer (11).

## Revendications

1. Procédé d'encapsulation d'au moins un composant (17) porté ou localement entouré par un corps de support (18) sur une galette, en particulier d'un composant ou élément capteur micromécanique, le composant (17) étant recouvert localement sur la surface du corps de support (18) avec une cavité (13) d'un système de couches (5) présentant une structure à cavités (20), de telle manière que la cavité (13) et le corps de support (18) enveloppent au moins en grande partie le composant (17),
**caractérisé en ce que**
le système de couches (5) présente au moins un corps de base (10) en une matière compatible avec la technologie des semi-conducteurs au silicium, en particulier un corps de silicium, une couche de séparation (11) et une couche de recouvrement (12).

2. Procédé selon la revendication 1,
**caractérisé en ce que**
la couche de recouvrement (12) est structurée avec la structure à cavités (20).

3. Procédé selon la revendication 2,
**caractérisé en ce que**
la couche de séparation (11) est formée par une couche sacrificielle.

4. Procédé selon la revendication 1,
**caractérisé en ce que**
la cavité (13) et le corps de support (18) sont assemblés dans une zone de contact (16) par du verre fondu ou une colle polymère.

5. Procédé selon la revendication 1,
**caractérisé en ce que**
la cavité (13) est pratiquée de manière à ne pas être en contact avec le composant (17).

6. Procédé selon la revendication 1,
**caractérisé en ce que**
la structure de couches (5) avec la structure à cavités (20) est assemblée, en particulier collée, à l'envers avec le corps de support (18).

7. Procédé selon la revendication 6,
**caractérisé en ce qu'**
après l'assemblage de la structure à cavités (20) avec le corps de support (18), la structure à cavités (20) est séparée du corps de base (10).

8. Procédé selon la revendication 7,
**caractérisé en ce que**
la séparation est effectuée par une dissolution ou une rupture de la couche de séparation (11).

9. Procédé selon la revendication 2,
**caractérisé en ce que**
la couche de séparation (11) est d'abord produite sur le corps de base (10), puis la couche de recouvrement (12) est produite sur la couche de séparation (11).

10. Procédé selon la revendication 2,
**caractérisé en ce que**
la couche de recouvrement (12) est d'abord produite et structurée sur le corps de base (10) et ensuite la couche de séparation (11) est produite entre la couche de recouvrement structurée (12) et le corps de base (10).

11. Procédé selon la revendication 9 ou 10,
**caractérisé en ce que**
la couche de recouvrement (12) et/ou la couche de séparation (11) sont déposées sur le corps de base (10).

12. Procédé selon la revendication 9 ou 10,
**caractérisé en ce que**
la couche de recouvrement (12) et/ou la couche de séparation (11) sont formées par une zone de la surface du corps de base (10).

13. Procédé selon la revendication 2,
**caractérisé en ce qu'**
on forme une couche de silicium poreuse comme couche de séparation (11).

14. Procédé selon la revendication 2,
**caractérisé en ce que**
la couche de recouvrement (12) est produite par croissance, en particulier épitaxiale, de silicium sur le corps de base.

15. Procédé selon la revendication 14,
**caractérisé en ce que**
la croissance est effectuée au cours d'un procédé d'épitaxie à basse température, par dépôt assisté par ions ou un procédé de dépôt chimique en phase vapeur.

16. Procédé selon au moins l'une quelconque des revendications précédentes,
**caractérisé en ce que**
la surface du corps de base (10) est d'abord pourvue d'une structuration, puis on crée la couche de séparation (11) et la couche de recouvrement (12) pour que la structuration de la surface du corps de base (10) se transfère dans la couche de recouvrement (12) et forme la structure à cavités (20).

17. Procédé selon au moins l'une quelconque des revendications précédentes,
**caractérisé en ce que**
la structuration de la structure de couches (5) ou de la couche de recouvrement (12) avec la structure à cavités (20) est effectuée avec un procédé de gravure au plasma, en particulier un procédé de gravure au plasma à grande vitesse, ou par un procédé de gravure chimique humide, en particulier une gravure avec une solution de KOH.

18. Procédé selon au moins l'une quelconque des revendications précédentes,
**caractérisé en ce qu'**
on produit une couche de recouvrement (12) qui comprend une couche partielle faiblement poreuse (14) et une couche partielle de recouvrement au moins en grande partie étanche au gaz, ou on produit une couche de recouvrement (12) légèrement poreuse.

19. Procédé selon au moins l'une quelconque des revendications précédentes,
**caractérisé en ce que**
le corps de base (10) est d'abord rendu poreux au moins en surface ou est pourvu d'une couche poreuse et est ensuite recuit, pour former une couche poreuse comprimée comme couche de recouvrement (12) séparée du corps de base (10) par une couche de séparation poreuse (11).
